# EUROPEAN PATENT APPLICATION

(11) **EP 2 804 363 A1**
(43) Date of publication of application: **19.11.2014**
(21) Application number: 13167970.6
(22) Date of filing: 16.05.2013
(51) Int. Cl.: H04M 1/03, H04M 1/04, H04M 1/725

(54) **Cover for electronic device**

(71) Applicant: Sonic Force Oy, 90240 Oulu (FI)
(72) Inventor: Soronen, Petri, 90240 Oulu (FI)
(74) Representative: Kolster Oy Ab

(57) **Abstract**

This document discloses a cover for a portable electronic device, comprising: a body arranged to accommodate the portable electronic device in a detachable manner and to provide a mechanical protection for the portable electronic device when the cover is attached to the portable electronic device; and a groove provided in a surface of the body that faces the portable electronic device, wherein a first end of the groove serving as an audio inlet is disposed at a location of an audio speaker and a second end of the groove serving as an audio outlet is disposed at an edge of the body, wherein a cross-sectional area of the groove enlarges from the first end towards the second end to provide a sound-amplifying audio channel, and wherein the groove is open from the first end to the second end such that a back surface of the portable electronic device attached to the cover encloses the groove from the first end to the second end.

## Description

### Field

The invention relates to covers of electronic devices such as mobile phones and tablet computers comprising at least one audio speaker.

### Background

There are available covers that are designed to protect portable electronic devices such as mobile phones and tablet computers.

### Brief description

The invention is defined by the independent claims.

Embodiments of the invention are defined in the dependent claims.

### List of drawings

Embodiments of the present invention are described below, by way of example only, with reference to the accompanying drawings, in which
Figure 1A illustrates an embodiment of a cover for an electronic device, wherein the cover comprises an audio channel according to an embodiment of the invention;
Figure 1B illustrates another embodiment of the cover for the electronic device;
Figures 2 to 4B illustrate further embodiments of the cover comprising the audio channel;
Figure 5 illustrates an embodiment of the cover extending to a front surface of the electronic device and comprising a protrusion;
Figures 6 and 7 further illustrate an embodiment of the protrusion comprising an audio channel; and
Figures 8 and 9 illustrate an embodiment where the cover comprises an active loudspeaker system.

### Description of embodiments

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned.

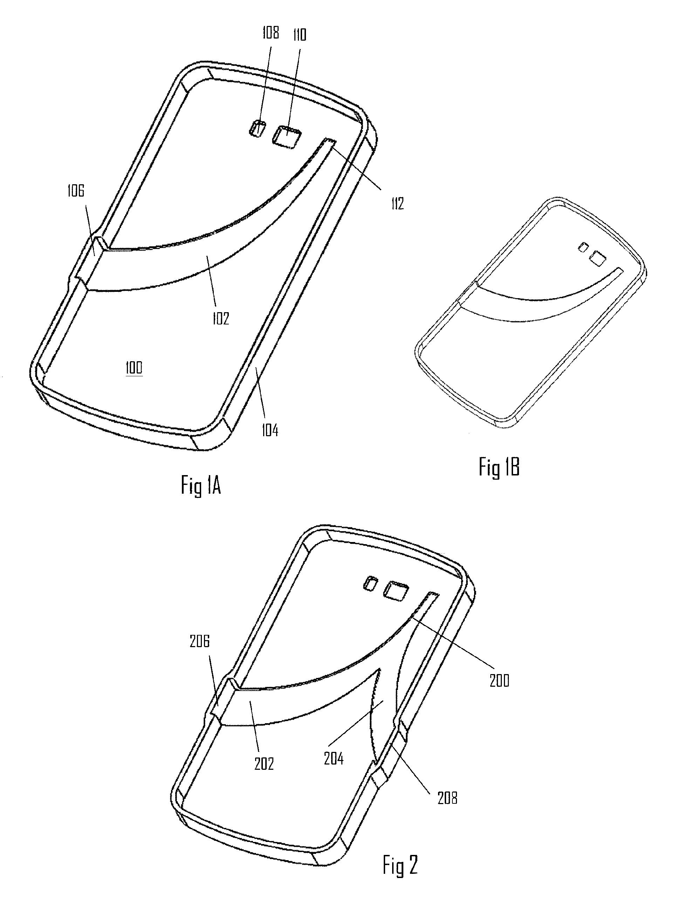

Figure 1A illustrates a cover for a portable electronic device according to an embodiment of the invention. The material of the cover may be any material suitable for protecting the electronic device, such as plastic, silicon, or wood. The cover comprises a body 100 designed to comply with outer forms and dimensions of the electronic device. Different electronic devices typically have different dimensions and different covers may be provided for different electronic devices. The portable electronic devices for which the covers according to the embodiments of the invention are designed may comprise cell phones, portable music or video players, and tablet computers. In general, the cover is suitable for any portable electronic device that comprises a loudspeaker. A problem with many such devices is that the loudspeaker is provided on a back side of the electronic device and, as a consequence, the sound provided by the loudspeaker is directed away from the user. This reduces both loudness and quality of the sound delivered to the user's ear.

Embodiments of the present invention provide a cover that comprises a sound channel that both directs the sound towards the user and passively amplifies the sound. In some embodiments, this may be achieved even without increasing the dimensions of the cover beyond the dimensions of conventional covers. The cover may be an accessory to the portable electronic device. The cover may be attached to a casing of the portable electronic device on top of a default back cover of the device, or it may replace the default back cover of the device. Referring to Figure 1A, the body 100 of the cover may be formed to accommodate the personal electronic device. The body 100 may comprise an inner surface that contacts with a back surface of the electronic device and edges 104 that enclose the electronic device from its sides. In some embodiments, the edges 104 may extend at least partially to a front surface of the electronic device to ensure proper fastening between the cover and the electronic device. In some embodiments, the body 100 may comprise one or more through holes 108, 110 for a camera lens and a flashlight, for example.

The cover further comprises a groove provided in the inner surface of the body 100. The groove provides an audio channel that directs the sound from the loudspeaker of the electronic device along the surface of the cover. A first end 112 of the groove serving as an audio inlet is disposed at a location of an audio speaker in the electronic device. As mentioned above, different electronic devices have different designs and, accordingly, the location of the first end may depend on the electronic device for which the cover has been designed. A second end 106 of the groove serving as an audio outlet is disposed at an edge 104 of the body 100. The audio channel is thus formed throughout the groove from the first end 112 to the second end 106. A cross-sectional area of the groove enlarges from the first end 112 towards the second end 106 to provide a sound-amplifying audio channel. The area may enlarge continuously such that the sound-amplification is realized in a similar manner as in horns. The enlargement may thus be designed such that the audio channel forms an impedance matching between a vibrating element of the loudspeaker of the electronic device and air, thus maximizing the efficiency of mechanical acoustic coupling between a speaker membrane and air such that amplification is realized. When the electronic device is not attached to the cover, the groove is open from the first end to the second end. When the electronic device is attached to the cover a back surface of the electronic device encloses the groove along the inner surface of the cover. Accordingly, the sound channel is realized by the groove together with the back surface of the electronic device. As shown in Figure 1, the sound channel is realized by the groove together with the back surface of the electronic device even at the outlet (the second end 106) where the sound waves exit the cover.

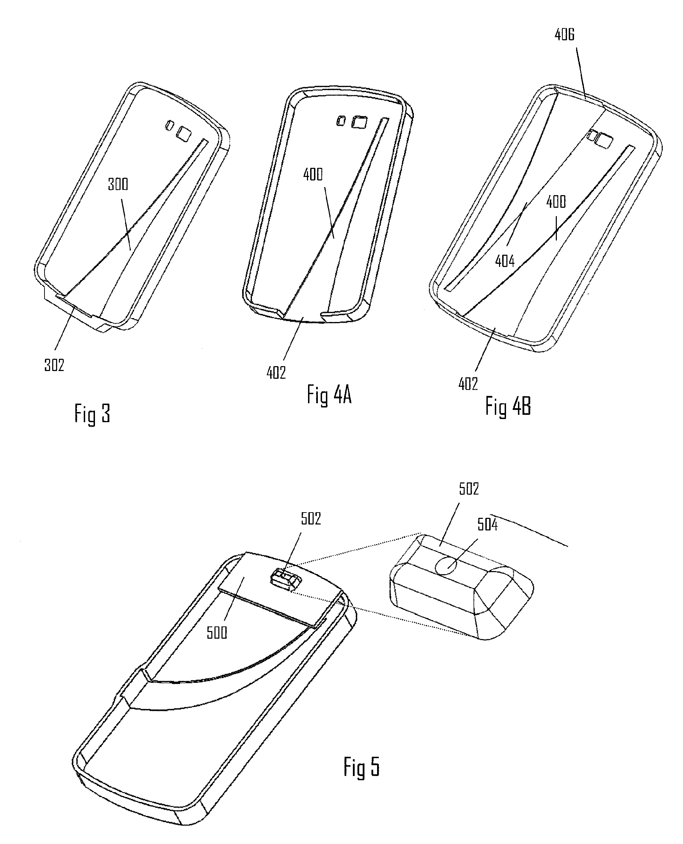

In an embodiment, the groove is elongated to enable the horn-like sound amplification. Its central axis may be curved as shown in Figure 1A or straight as in Figure 4. A cross-sectional view of the groove may be rectangular with sharp or rounded edges. The enlargement of the cross-sectional area may be realized by increasing the width of the groove while maintaining the depth substantially constant. In this manner, the thickness of the cover may be maintained small.

As shown in Figure 1A, the groove 102 guides the sound along the back surface of the electronic device from the location of the speaker towards an edge of the cover. The dimensions of the groove may be designed according to desired characteristics of the sound amplification. Desired amplification characteristics may be created by tuning properties of the horn, e.g. the length and expansion rate of the cross-sectional area of the groove. The expansion of the groove may be realized by enlarging the width and/or the depth of the groove. In an embodiment, the groove extends across the surface of the cover that faces the back surface of the electronic device. For example, the groove may start at a first half or quarter of the surface and extend to an edge of the opposite half or quarter of the cover.

At the edge 104 of the cover the groove may continue in a direction perpendicular to the plane of the back surface of the electronic device, i.e. along a side surface of the electronic device. For that purpose, the second end 106 of the groove may be formed into an inner surface of the edge 104 of the cover. In this manner, the sound is guided along the side surface and towards the user. The cross-sectional area may enlarge in the edge area of the groove. In other embodiments, the groove provided along the inner side surface of the cover has a constant cross-sectional area.

In an embodiment, an outer side surface on the side where the audio outlet is disposed may comprise a protrusion (see Figure 1A) to accommodate the audio outlet. In another embodiment, the outer side surface may have a constant thickness from the location of the audio outlet (including the audio outlet) to at least one end of the outer side surface such that there is no distinct protrusion (see Figure 1B). For example, the depth of the groove may decrease and the width of the groove may increase in the sound outlet (the second end 106). The depth of the groove may be less than two millimetres at the sound outlet and, thus, the protrusion may be omitted with the proper design of the thickness of the cover.

Figure 2 illustrates an embodiment where the audio channel 200 branches into two audio channels 202, 204. In other embodiments, the number of audio channel branches may be higher than two. Accordingly, the elongated groove may branch. The audio channel may comprise the audio inlet, as described above, and at least two audio outlets 206, 208 at different locations on the edge(s) of the cover. The audio outlets 206, 208 may be provided on opposite edges of the cover, as shown in Figure 2. The form of the audio channel may be designed such that the cross-sectional surface of the audio channel constantly enlarges even in the area of branching. In other words, the enlarging may occur constantly without a distinct step in the cross-sectional area at the branching area. This ensures that horn-like properties are maintained even in the case of splitting the audio channel. Each branch 202, 204 may then enlarge from the branching area towards the respective audio outlet. This ensures that the total cross-sectional area of different branches increases within the same specifications regardless of the number of branches of the particular cover. In some embodiments, each branch has a separate audio outlet, while in other embodiments at least one of the branches has no audio outlet while at least one other branch has an audio outlet.

Figures 3, 4A, and 4B illustrate embodiments where the central axis of the audio channel 300, 400 is substantially straight. In these embodiments, the audio channel 300, 400 extends from the first end (the location of the loudspeaker in the electronic device) towards an edge which is most distant from the first end. In the embodiment of Figure 3, the audio outlet 302 is formed into the cover such that the audio channel turns a determined angle such that the outlet 302 is directed towards the user, as in the embodiments of Figure 1 and 2. The angle may be between 60 and 120 degrees, e.g. 90 degrees. Accordingly, the edge of the cover comprising the outlet is enclosed in the direction in which the sound propagates along the back surface of the electronic device. In the embodiment of Figure 4A, the edge comprising the outlet 402 is open in this direction. Accordingly, the audio outlet 402 directs the sound out of the cover along a plane of the back surface of the electronic device. This embodiment has the advantage that the thickness of the edge of the outlet 402 may be designed very thin, since no sound guidance members are needed to turn the sound channel. The embodiment of Figure 4B comprises a second straight audio channel 404 leading to the opposite direction. The second audio channel 404 may comprise an outlet 406 at an opposite or different edge of the cover than the edge of the outlet 402. This embodiment is applicable to electronic devices comprising two audio speakers on the back surface. In further embodiments, one of the audio channels may be straight while the other is curved.

It should be appreciated that the design of the groove may be arbitrary, e.g. the groove may twist, turn, or zigzag within the inner surface of the cover as long as it functions as guide and amplifies the sound waves in a controlled manner.

As described above, the cover may enclose the electronic device and cover at least partially the back surface and some or all side surfaces of the electronic device. In some embodiments, the cover may extend at least partially to a front surface of the electronic device. The front surface may comprise a display screen and a sound output for a voice call, e.g. a second audio speaker of the electronic device. Extension to the front surface may ensure the proper attachment of the cover to the electronic device.

The audio speaker described above may be used when the user is watching or operating the display screen of the electronic device, e.g. watching a video, listening to music via the speaker, or having a telephone conference call via the speaker. In many mobile phones, there is a second sound output, e.g. a second speaker or an earpiece, designed to be placed against the user's ear when having a voice call. As the volume level of this second sound output is typically low and the front surface of the mobile phones is typically flat, it may be difficult to position the second output properly against the ear. In some mobile phones, the second sound output may be disposed in a location which is not intuitive for some users to place against the ear, e.g. the very top edge of the mobile phone.

Figures 5 to 7 illustrate an embodiment where the cover extends to contact the front surface of the electronic device. The cover may comprise a front surface 500 which contacts the front surface of the electronic device. The front surface 500 of the cover may be designed to cover the above-described second sound output of the electronic device. A protrusion 502 may be provided on an outer face of the front surface 500 of the cover, and the protrusion may extend away from the electronic device. The protrusion 502 may locate over the second sound output of the electronic device.

In an embodiment, the protrusion is dimensioned to function as a positioning reference for aligning the mobile phone against a user's ear. Accordingly, the dimensions of the protrusion may be designed to be smaller than a recession in a human ear flap such that the user may align the protrusion 502 against edges of the recession and substantially over an ear canal of the respective ear. The protrusion may guide the user to place the phone such that the protrusion is over a concha next to an ear canal of the user. In this manner, the second sound output may be disposed at an optimal location right over the concha and the sound canal. Dimensions of protrusion are such that it fits to anti-helix main dimensions of the ear.

It should be appreciated that the protrusion is in some embodiments provided in a cover comprising the sound channel provided by the groove. In other embodiments, the cover may comprise the protrusion without the groove.

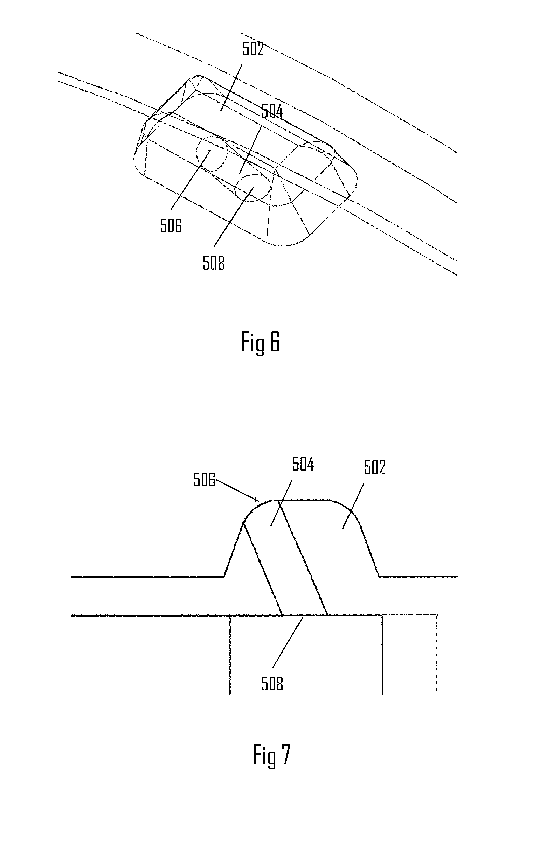

The protrusion 502 may comprise a through hole 504, as illustrated in Figures 6 and 7. The through hole may extend through the front surface 500 of the cover and the protrusion 502. A first end 508 of the through hole 504 may be provided on an inner surface of the front surface 500 of the cover and, thus, faces the sound output provided on the front side of the electronic device. A second end 506 of the through hole 504 may be provided at a different location than the first end 508 when viewed along the front surface of the electronic device. The through hole functions as a sound channel that directs the sound from the sound output to a desired direction. As the through hole is arranged as inclined with respect to the front surface of the electronic device and to a normal of a plane of the front surface, the through hole 504 shifts an audio output from the (second) sound output along the front surface of the electronic device. This embodiment has an advantage particularly with electronic devices comprising the sound output very close to the edge of the front surface, because the sound output may be shifted further away from the edge to a location which is more convenient to place against the ear. Accordingly, enhancement in the sound volume experienced by the user may be increased.

As illustrated in Figures 6 and 7, the sound channel provided by the through hole 504 is inclined with respect to the protrusion 502, and the second end 506 of the through hole 504 may be provided on top of the protrusion 502 or at least partially on a side of the protrusion 502.

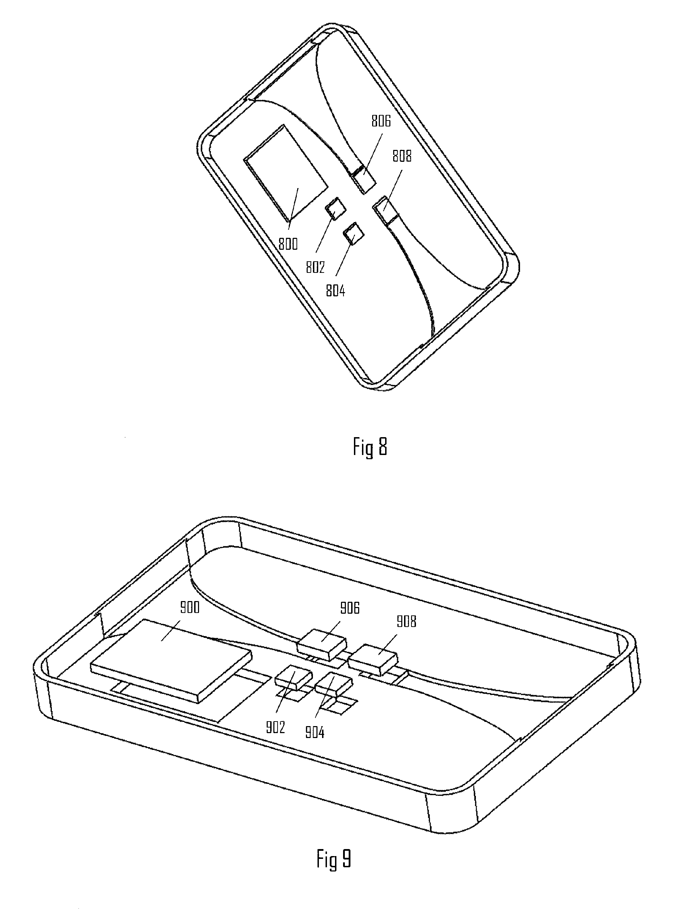

In an embodiment illustrated in Figures 8 and 9, the cover comprises an active loudspeaker system. Referring to Figure 8, the cover may comprise at least one housing, cavity or a recession 800, 802, 804, 806, 808 for the active loudspeaker system. The active loudspeaker system may comprise at least one audio speaker 906, 908, and the first end of the groove serving as the audio inlet may be disposed at a location of the audio speaker 906, 908 of the cover. As shown in Figures 8 and 9, the audio speakers 906, 908 may be disposed in corresponding housings 806, 808. The cover may further comprise an amplifier circuitry 904 disposed in its housing 804 in the cover and configured to amplify a sound produced by the electronic device and to output the amplified sound to the audio channel via the audio speaker(s) 906, 908 of the cover. A wiring (not shown) may be provided between the amplifier circuitry 904 and the audio speaker(s) in the cover. An input to the amplifier circuitry 904 may be provided from a connector that connects to an electric audio output of the electronic device. In some electronic devices, the electric audio output may be obtained from a determined pin of an electric output of the electronic device. Alternatively, the electronic device may comprise an electric audio output interface such as a 3.5 millimetre audio jack socket. The connector connecting the electric audio output and the amplifier circuitry 904 may be provided inside the cover. At least that part which connects to the electric audio output may, however be exposed to ensure the electric connection. In yet another embodiment, the input to the amplifier circuitry 904 may be provided by a wireless communication circuitry, e.g. a Bluetooth circuitry 902, disposed in its housing 802 in the cover, and the wireless communication circuitry may communicate with the electronic device wirelessly and stream audio signals from the electronic device to the amplifier circuitry 904. The amplifier circuitry along with any batteries 900 etc. may be integrated into one or more cavities 800 provided in the cover. The audio speaker(s) 906, 908 of the cover may be exposed, and the audio inlet of the sound channel, e.g. the audio inlet 112, may be disposed at the location of the loudspeaker such that the sound output from the loudspeaker enters the sound-amplifying channel 102, 200, 202, 204, 300, 400.

It should be appreciated that the above description of some embodiments of the invention is intended for illustrative purposes, and a person skilled in the art is able to make many modifications to the described embodiments. Therefore, all words and expressions should be interpreted broadly and they are intended to illustrate, not to restrict, the embodiments. The invention and its embodiments are thus not limited to the examples described above but may vary within the scope of the claims.

## Claims

1. A cover for a portable electronic device, comprising:
a body arranged to accommodate the portable electronic device in a detachable manner and to provide a mechanical protection for the portable electronic device when the cover is attached to the portable electronic device;
a groove provided in a surface of the body that faces the portable electronic device, wherein a first end of the groove serving as an audio inlet is disposed at a location of an audio speaker and a second end of the groove serving as an audio outlet is disposed at an edge of the body, wherein a cross-sectional area of the groove enlarges from the first end towards the second end to provide a sound-amplifying audio channel, and wherein the groove is open from the first end to the second end such that a back surface of the portable electronic device attached to the cover encloses the groove from the first end to the second end.

2. The cover of claim 1, wherein the surface on which the groove is provided is a plane that faces the back surface of the portable electronic device and contacts the back surface of the electronic device so as to enclose the groove.

3. The cover of claim 2, wherein the groove continues from said plane to at least one inner side surface of the cover and extends from said plane along the side surface towards a front side of the portable electronic device such that the audio signal conducted in the audio channel is directed towards a user of the portable electronic device.

4. The cover of any preceding claim, wherein the groove branches into at least two audio channels and wherein each branch has a separate audio outlet.

5. The cover of claim 4, wherein the audio outlets are provided on different edges of the body.

6. The cover of any preceding claim, wherein the first end of the groove serving as an audio inlet is disposed at a location of an audio speaker of the portable electronic device.

7. The cover of any preceding claim, wherein the cover comprises at least audio speaker and wherein the first end of the groove serving as an audio inlet is disposed at a location of the audio speaker of the cover.

8. The cover of claim 7, wherein the cover further comprises a circuitry configured to amplify a sound produced by the portable electronic device and to output the amplified sound to the audio channel via the audio speaker of the cover.

9. The cover of any preceding claim, wherein the cover is designed to cover a mobile phone, wherein edges of the cover are arranged to enclose the mobile phone at least at its edges, the cover further comprising:
a protrusion disposed on a part of the cover that faces a front surface of the mobile phone and at a location where an audio output is provided on the front surface of the mobile phone, wherein the protrusion extends away from the front surface;
a through hole provided through the protrusion and forming a second audio channel from the audio output on the front surface of the mobile phone to an edge of the protrusion, wherein a first end of the through hole is provided on an inner surface of the cover and faces the audio output provided on the front surface of the mobile phone, and wherein a second end of the through hole is provided at a different location than the first end when viewed along the front surface of the mobile phone such that the through hole shifts an audio output along the front surface of the mobile phone.

10. The cover of claim 9, wherein the protrusion is arranged to function as a positioning reference for aligning the mobile phone against a user's ear.

11. The cover of any preceding claim, wherein the cover is an accessory to the portable electronic device.
